# EUROPEAN PATENT APPLICATION

(11) **EP 4 752 188 A1**
(43) Date of publication of application: **03.06.2026**
(21) Application number: 24383296.1
(22) Date of filing: 29.11.2024
(51) Int. Cl.: C09K 11/02, C09K 11/88, H10H 20/00

(54) **A QUANTUM DOT POPULATION COMPRISING SILVER CHALCOGENIDE QUANTUM DOTS, A METHOD FOR OBTAINING THE QUANTUM DOT POPULATION AND AN OPTOELECTRONIC DEVICE COMPRISING THE QUANTUM DOT POPULATION**

(71) Applicant: ICFO - Institut de Ciències Fotòniques, 08860, Castelldefels (ES); Institució Catalana de Recerca i Estudis Avançats (ICREA), 08010 Barcelona (ES)
(72) Inventor: KONSTANTATOS, Gerasimos, 08860 CASTELLDEFELS (ES); WANG, Yongjie, 08860 CASTELLDEFELS (ES)
(74) Representative: Ponti & Partners, S.L.P

(57) **Abstract**

The present invention relates to a quantum dot population comprising silver chalcogenide quantum dots, wherein the silver chalcogenide quantum dots do not include phosphine or halide.

The present invention also relates to a method for obtaining the quantum dot population of the invention, and to an optoelectronic device comprising the quantum dot population.

## Description

The authors acknowledge financial support from the European Research Council (ERC) under the European Union's Horizon 2020 research and innovation programme (grant agreement no. 101002306).

### FIELD OF THE INVENTION

The present invention generally relates, in a first aspect, to a quantum dot population comprising silver chalcogenide quantum dots absent of phosphine and absent of halides.

A second aspect of the present invention relates to a method for obtaining the quantum dot population of the first aspect of the present invention.

A third aspect of the present invention relates to an optoelectronic device comprising the quantum dot population of the first aspect of the present invention.

### BACKGROUND OF THE INVENTION

Short-wavelength infrared (SWIR) light has possessed numerous applications, including optical communications, spectroscopy, biological imaging, surveillance, and machine vision [1-10]. However, commercial devices serving in the SWIR region are still largely based on expensive epitaxy materials.

Recently, solution-processed quantum dots emerged as promising yet low-cost substitutes for NIR/SWIR applications [3-5,11]. However, currently most of NIR/SWIR quantum dots are based on lead chalcogenides or mercury chalcogenides. The toxicity of lead and mercury severely limits the availability of those materials for consumer-oriented devices.

The desire for non-toxic, solution-processed materials in the NIR/SWIR region has ignited researches on silver chalcogenides, especially silver telluride (Ag₂Te), as promising candidates for optoelectronic applications in NIR/SWIR region [6]. However, current synthesis of size-tuned silver telluride quantum dots are based on halide precursors, which might induce photo instability and voltage bias instability.

It is, therefore, necessary to provide an alternative to the state of the art by providing phosphine- and halide-free silver chalcogenide quantum dots, a method for synthesizing silver chalcogenide quantum dots with a phosphine free and halide free process, targeting high performance optoelectronic devices.

### References:

1. Ni, H. et al. Millimetre-deep micrometre-resolution vibrational imaging by shortwave infrared photothermal microscopy. Nat. Photonics 1-8 (2024) doi: 1 0.1 038/s41566-024-01463-6.
2. Naczynski, D. J. et al. Rare-earth-doped biological composites as in vivo shortwave infrared reporters. Nat. Commun. 4, 2199 (2013).
3. Liu, J. et al. A near-infrared colloidal quantum dot imager with monolithically integrated readout circuitry. Nat. Electron. 5, 443-451 (2022).
4. Liu, Z. et al. Short-Wave Infrared Light-Emitting Diodes Using Colloidal CulnS2 Quantum Dots with Znl2 Dual-Passivation. ACS Nano (2024) doi: 10.1021/acsnano.4c06559.
5. Sergeeva, K. A. et al. The Rise of HgTe Colloidal Quantum Dots for Infrared Optoelectronics. Adv. Funct. Mater. n/a, 2405307.
6. Wang, Y. et al. Silver telluride colloidal quantum dot infrared photodetectors and image sensors. Nat. Photonics 18, 236-242 (2024).
7. Zlatanovic, S. et al. Mid-infrared wavelength conversion in silicon waveguides using ultracompact telecom-band-derived pump source. Nat. Photonics 4, 561-564 (2010).
8. Atan, O. et al. Control over Charge Carrier Mobility in the Hole Transport Layer Enables Fast Colloidal Quantum Dot Infrared Photodetectors. Nano Lett. acs.nanolett.3c00491 (2023) doi:10.1021/acs.nanolett.3c00491.
9. Morteza Najarian, A. et al. Sub-millimetre light detection and ranging using perovskites. Nat. Electron. 5, 511-518 (2022).
10. Ollearo, R. et al. Ultralow dark current in near-infrared perovskite photodiodes by reducing charge injection and interfacial charge generation. Nat. Commun. 12, 7277 (2021).
11. Yang, J. et al. Ligand-Engineered HgTe Colloidal Quantum Dot Solids for Infrared Photodetectors. Nano Lett. 22, 3465-3472 (2022).

### SUMMARY OF THE INVENTION

To that end, the present invention relates, in a first aspect, to a quantum dot population comprising silver chalcogenide quantum dots, wherein, in contrast to the prior art quantum dot populations, the silver chalcogenide quantum dots do not include phosphine or halides, i.e. are phosphine- and halide-free.

For an embodiment, the silver chalcogenide quantum dots are synthesized silver chalcogenide quantum dots, while for other embodiments the silver chalcogenide quantum dots are silver chalcogenide quantum dots obtained by means of non-synthesis processes (decomposition, single or double replacement, etc.) or are byproducts or sub-products of a chemical reaction.

Depending on the embodiment, the chalcogenide ion of the silver chalcogenide of the silver chalcogenide quantum dots is selected from sulfide, selenide, telluride, or combinations thereof.

In other words, the silver chalcogenide is represented by AgᵢXⱼ in which X can be S, Se, Te, or combinations thereof, and wherein i is generally 2 (1 < i < 3) and j is 1.

According to an embodiment, the silver chalcogenide quantum dots are passivated by amines and thiols.

For an implementation of that embodiment, the silver chalcogenide quantum dots are passivated by oleylamine and 3-mercaptopropionic acid, 1-octanethiol, 1-dodecanethiol, 1-hexadecanethiol, 1-octadecanethiol, or their combinations thereof.

For an embodiment, the silver chalcogenide quantum dots of the quantum dot population of the first aspect of the present invention have distinct excitonic absorption peak, having a peak-valley ratio > 2, tuned from 1000nm to 2000nm, preferably above 1300nm.

Different methods for measuring exciton absorption are known in the art and can be used in the present invention for determining said distinct excitonic absorption peak, such as the following method: the peak-valley ratio, which is the intensity ratio between the first excitonic peak and the valley in the absorption spectra.

For some embodiments, the quantum dot population of the first aspect of the present invention forms a structure, such as sheet, a film, or a layer, or an ink.

In a second aspect, the present invention relates to a method for obtaining the quantum dot population of the first aspect, wherein the method comprises obtaining the silver chalcogenide quantum dots without using phosphine or halide.

For an embodiment of the method of the second aspect of the present invention, the method comprises:
- preparing silver precursor from amines and one or more silver compounds (such as silver acetate, silver nitrate, etc);
- preparing chalcogenide precursor from chalcogen oxide (such as SeO₂, TeO₂, or combinations thereof) and thiols (such as 1-dodecanethiol, 1-hexadecanethiol, 1-octadecanethiol, etc); and
- synthesizing the silver chalcogenide quantum dots by injecting both the silver precursor and the chalcogenide precursor into a solution, such as according to a hot-injection method (understood as a method embracing both injecting precursors with lower temperature than the solvent temperature, and also injecting precursors with higher temperature than the solvent temperature).

For an embodiment, an amount > 0.1mL of silver precursor and/or an amount >0.1mL of chalcogenide precursor are injected into said solution.

According to an embodiment, the method of the second aspect of the present invention comprises providing the above mentioned solution by loading pre-dried hydrocarbon solvents under inert atmosphere (such as that formed by N₂, Ar, or combinations thereof) heating at a temperature between 20°C and the boiling point of said pre-dried hydrocarbon solvents.

For an embodiment, the method further comprises adding extra metal precursor as post-synthesis treatment, or stabilizing process, to stabilize the silver chalcogenide quantum dots in solvents without ripening. Here, the mentioned metal precursor includes but is not limited to zinc acetate, zinc nitrate, indium acetate, indium nitrate, tin acetate, tin nitrate, antimony acetate, antimony nitrate, copper acetate, copper nitrate, etc.

For an embodiment, the method further comprises adding another bifunctional molecule as post-synthesis treatment, for stabilization and surface passivation. Here the mentioned molecule characterizes in containing both carboxyl and thiol function groups and includes but is not limited to 3-mercaptopropionic acid, 4-mercaptobutyl acid, etc.

For an implementation of that embodiment, the stabilizing process comprises:
- adding extra metal precursor(s) and/or 3-mercaptopropionic acid to passivate the QD (quantum dot) surfaces;
- providing a stable silver chalcogenide quantum dots with tuneable size and monodispersity.

According to an embodiment, said step of adding extra metal precursor as post-synthesis treatment comprises at least one cycle of adding a desired amount of extra metal precursor after reaction crude solution cooling down and purification.

For an implementation of said embodiment, the desired amount of extra metal precursor is > 1mg and/or the purification is made with an anti-solvent which is at least one of methanol, acetone, isopropanol, ethanol, acetonitrile, or mixture thereof.

According to an embodiment, alternative to the one described above related to an injection method, the method of the second aspect of the present invention comprises:
- preparing silver precursor from amines and at least one of silver compound, such as silver acetate, silver nitrate, etc;
- preparing chalcogenide precursor from chalcogen oxide and thiols; and
- loading said silver and chalcogenide precursors in a hydrocarbon solvent followed by a heat-up process from room temperature to the boiling point of said hydrocarbon solvent.

For an embodiment, for any of the above-described embodiments, the hydrocarbon solvent is a mixture of oleylamine and 1-octadecene.

For an embodiment, the thiols, for any of the above-described embodiments, are at least one of alkyl thiols and their mixture, and/or the above-mentioned amines are at least one of the primary amines and their mixture.

According to an embodiment of the method of the second aspect of the present invention comprises:
- the step of preparing silver precursor from silver acetate comprises pre-drying amines under vacuum and dissolving silver acetate in pre-dried amines with various concentrations (such as from 0.01 to 3 mol/L) at mild temperature, between 20°C and 100°C, in inert atmosphere (such as that formed by N₂, Ar, or combinations thereof);
- the step of preparing chalcogenide precursor comprises mixing chalcogen oxide with thiols in inert atmosphere under mild temperature heating, between room temperature and 150°C, and continuous inert gas bubbling.

For an embodiment of the method of the second aspect of the present invention, the silver chalcogenide quantum dots are organic ligands capped silver chalcogenide quantum dots, and the method further comprises performing a ligand-exchange on surface of the silver chalcogenide quantum dots, for providing the same with ligands with a shorter chain than said organic ligands (such as, silver nitrate, 1,2-ethanedithiol, ethanethiol, 1,3-propionedithoil, propanethiol, etc) than said organic ligands (which have a long chain, defined as generally with more than four carbons, typically more than eight carbons). Surface ligand-exchange is to improve the electric conductivity, for example of a nanocrystal film comprising those silver chalcogenide quantum dots for optoelectronic devices.

For an embodiment, 1,2-ethanedithiol (EDT) is used to ligand-exchange MPA-oleylamine on the surface of the silver chalcogenide quantum dots.

For an embodiment, silver nitrate (AgNO₃) is used to ligand-exchange MPA-oleylamine on the surface of the silver chalcogenide quantum dots and further control the doping density of quantum dot films.

For an alternative embodiment, the method of the second aspect of the present invention further comprises preparing an ink with the obtained silver chalcogenide quantum dots, by performing the following steps:
- preparing a silver chalcogenide quantum dot solution by dissolving organic ligands capped silver chalcogenide quantum dots into a first solvent; said organic ligands have a long chain, defined as generally with more than four carbons, typically more than eight carbons;
- preparing a ligand solution by dissolving desired ligands (such as, 3-mercapto propionic acid, 2-mercaptoethanol, metal salt complexes, etc.) into a second solvent, wherein said second solvent is not miscible with said first solvent, and wherein said desired ligands have a shorter chain than said organic ligands, generally with less than six carbons, typically less than three carbons;
- doing phase transfer ligand exchange by mixing said silver chalcogenide quantum dot solution with said ligand solution, wherein two phases are obtained: a first phase containing said first solvent and exchanged organic ligands (which are previously capped on quantum dots during synthesis, such as oleylamine, 1-dodecanethiol, etc.), and a second phase containing said second solvent with ligand-exchanged quantum dots;
- precipitating said ligand-exchanged quantum dots by adding a third solvent into the second phase; and
- preparing quantum dot inks by dissolving said ligand-exchanged silver chalcogenide quantum dots into a fourth solvent.

Other desired properties provided by the desired ligands are like forming strong binding with the surface ions and providing colloidally stable dispersions.

Generally, the first and third solvents are apolar solvents and the second and fourth solvents are polar solvents.

For some embodiments, the second and fourth solvents are at least one of or mixture of hydrocarbon solvents or their derivatives with functional groups containing elements of oxygen, nitrogen, sulfur, phosphorus, or boron.

For an embodiment, the first solvent is octane, the second solvent is N, N-dimethylformamide (DMF), the third solvent is toluene, and the fourth solvent is neat DMF.

For some embodiment, the desired ligands are or comprise at least one of thiols, amines, metal salts, metal chalcogenide complex or their mixture.

Thanks to the above mentioned ligand-exchange, the silver chalcogenide quantum dot are easily dissolved and well-dispersed, and thus the ink can be prepared.

The so prepared ink can be applied by spin-coating or printing onto a substrate or lower sheet or layer, for manufacturing a device, such as an optoelectronic device, according to a manufacturing method of a further aspect of the present invention.

For some embodiments, the method of the second aspect of the present invention further comprises shelling the silver chalcogenide quantum dots with a shell made of a phosphine- and halide-free material. This material may comprise a metal-chalcogenide compound (such as a silver chalcogenide compound, ZnS, ZnSe, ZnTe, etc.) or metal oxide (such as TiO2, SiO2, TeO2, ZnO etc.) or combinations thereof, to provide quantum dots with phosphine- and halide-free core-shell structures. This shelling improves thermal stability of the silver chalcogenide quantum dots and, for some applications, improves the photoluminescence quantum yield.

In a third aspect, the present invention relates to an optoelectronic device, comprising the quantum dot population of the first aspect of the invention.

For an embodiment of the optoelectronic device of the third aspect of the present invention, the quantum dot population is provided in the form of a sheet or layer previously formed or by spin-coating onto a substrate or lower sheet or layer.

According to an embodiment, the optoelectronic device of the third aspect of the present invention implements a photodetector device, while for other embodiments the optoelectronic device implements a light emitting device or an image sensor.

For an embodiment, the optoelectronic device comprises a light absorbing structure (such as a sheet, film or layer) comprising the above described quantum dot population and made to absorb, in the visible spectrum and/or at least one of infrared light, near infrared light, and short-wavelength infrared light.

### BRIEF DESCRIPTION OF THE FIGURES

In the following some preferred embodiments of the invention will be described with reference to the enclosed figures. They are provided only for illustration purposes without however limiting the scope of the invention. In accordance with common practice, the components in the figures are drawn to emphasize specific features and they are not drawn to the right scale.

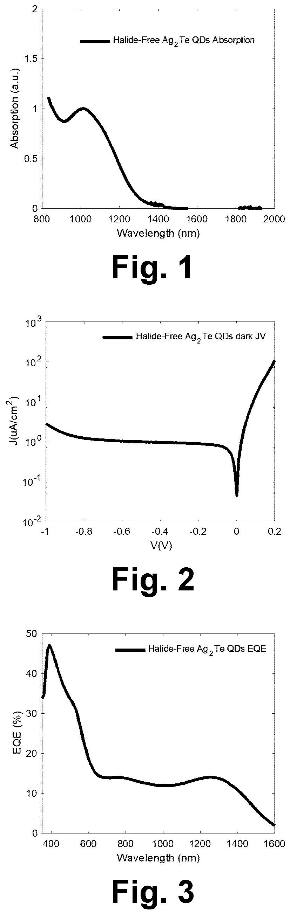

Figure 1 shows a typical absorption spectrum of Ag₂Te QDs (quantum dots) in toluene with an excitonic peak ~1000nm. The size can be tuned with reaction temperature and continuous precursor supply method.
Figure 2 presented the typical dark current density - voltage (*J-V*) curve of photodiode devices made from phosphine-free halide-free Ag₂Te QDs, according to an embodiment of the third aspect of the present invention. The reverse dark current density under -0.6V reached ~1uA/cm², lower than devices with halide-QDs, hypothetically due to reduced trap density, since Ag-halides are more sensitive than silver acetates to ambient light illumination, which is unavoidable during material synthesis and device fabrication.
Figure 3 showed a typical EQE spectrum of photodiode made of phosphine-free halide-free Ag₂Te QDs, according to an embodiment of the third aspect of the present invention, with a peak EQE over 10% in the short-wave infrared region. Higher EQEs are anticipated with further device optimizations.
Figure 4 is a plot showing the absorption spectrum of Ag₂Te QDs in toluene with an excitonic peak ~1300nm, obtained with the method of the second aspect of the invention, for an embodiment. It shows distinct absorption peak with peak-valley ratio > 2.
Figure 5 is a plot showing the absorption spectrum of an ink of Ag₂Te quantum dots obtained with the method of the second aspect of the invention, for another embodiment. The resulting Ag₂Te quantum dots show first exciton peak at ~1350nm. It also shows a distinct excitonic absorption peak, having a peak-valley ratio > 2.

### DESCRIPTION OF THE PREFERRED EMBODIMENTS

In the present section, by means of several experiments detailed below, the present inventors demonstrate the feasibility and good results offered by the present invention, specifically for embodiments for which the silver chalcogenide quantum dots of the quantum dot population of the first aspect of the invention are Ag₂Te quantum dots.

Specifically, with respect to the method of the second aspect of the invention, it is here demonstrated that the present invention provides a facile, phosphine-free and halide-free synthesis method and post-synthesis stabilizing strategy for size controllable Ag₂Te quantum dots, which allows distinct excitonic absorption peak tunable from 1000nm to ~2000nm. The post-synthesis stabilizing strategy is achieved by adding excess metal precursor and 3-MPA to passivate the QD surfaces and further obtain Ag₂Te quantum dots passivated predominately by MPA-oleyamine and small amount of DDT.

Here, the present inventors demonstrate for the first time size-controllable, monodispersed Ag₂Te quantum dots with distinct excitonic peak (peak-valley ratio > 2) from 1000nm to 2000nm based on phosphine free and post-synthesis stabilizing strategy.

### Examples:

### Phosphine-free and halide-free synthesis of Ag₂Te QDs.

A mixture of 30mL Oleylamine (OLAm) and 15mL 1-octadecene (ODE) was loaded into a 100mL flask and degassed under vacuum at 100°C for 2 hours. In the meantime, 3mmol (700mg) silver acetate (AgOAc) was dissolved into 5mL pre-dried OLAm under inert atmosphere at 50°C to prepare silver precursor. 200mg tellurium oxide (TeO₂) was dissolved into 5mL 1-dodecanethiol (DDT) at 100°C with continuous Ar bubbling to prepare 0.25M Te-DDT precursor. The temperature of OLAm/ODE mixture was then raised to 130°C and the flask is refilled with Ar. When the temperature is stable, 3 mL Silver precursor was injected into OLAm/ODE mixture, followed by injecting 5mL Te-DDT precursor. The solution color darkens immediately after injection Te-DDT precursor and the solution temperature was kept at 130°C for ten more minutes before removing heating mantle and cooling down naturally.

### Post-treatment and purification

Metal salts powder was added into the reaction solution after cooled down to room temperature. The solution was left stirring until all metal salts were dissolved. *Ligands-II* added dropwise into the reaction solution under continuous stirring. The reaction solution was left overnight, followed by purification in an inert-gas filled glovebox. Methanol was added into the solution as an anti-solvent, followed by a 6krpm, 5min centrifuge to precipitate the QDs. The QD solids were dissolved into a mixture solvent of toluene/oleylamine/ *ligands-II.* After QDs fully dissolved, Methanol was added again as the anti-solvent to precipitate the QDs with 6krpm/5min centrifuge. The QDs solids were finally dissolved into toluene and kept in glovebox.

The metal salts mentioned above include but not limited to the following compounds or their combinations thereof: silver nitrate AgNOa, silver acetate AgOAc, zinc nitrate Zn(NO₃)₂, zinc acetate Zn(OAc)₂, indium acetate In(OAc)₃, indium nitrate In(NO₃)₃, tin acetate (Sn(OAc)₂, Sn(OAc)₄), tin nitrate (Sn(NO₃)₂, Sn(NO₃)₄), copper nitrate (Cu(NO₃)₂), copper acetate (Cu(OAc)₂), etc.

The *Ligands-II* mentioned above indicates all the ligands with both -SH and - COOH function groups. This includes but is not limited to mercaptopropionic acid, mercaptobutyric acid, etc.

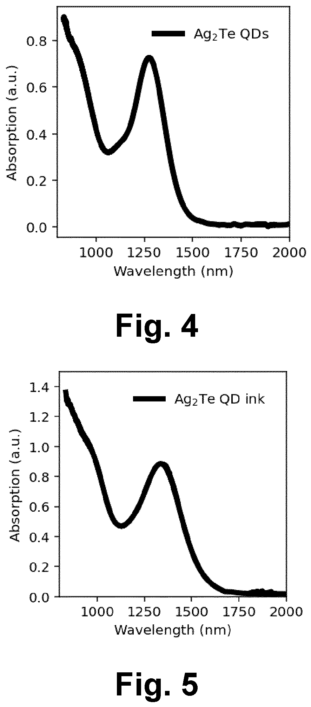

Figure 4 shows the absorption spectrum for a solution of Ag2Te quantum dots obtained with the method of the second aspect of the invention, for an embodiment. The resulting Ag₂Te quantum dots show first exciton peak at ~1300nm, and could be used to fabricate a light absorbing film. It also shows a distinct excitonic absorption peak, having a peak-valley ratio > 2.

### Example for ink preparation:

Ag₂Te QD solution was prepared by dissolved Ag₂Te QDs in octane (first solvent) with a concentration of 10 mg/mL. The ligand solution was prepared with dissolved 3-mercaptopropionic acid (MPA) into N, N- dimethylformamide (DMF) (second solvent) with a concentration of 1%. 10mL QD/Octane solution was then mixed with 10mL ligand solution, followed by vigorous mixing until a clear phase separation was observed. The DMF phase was then extracted and the octane phase was discarded. The DMF phase, which contains QDs, was then mixed with 10mL neat octane (first solvent) and extracted again. This step was repeated two more times. Finally, the QDs/DMF phase was mixed with 10mL toluene (third solvent) to precipitate the QDs, followed by centrifugation at 6000rpm for 3min. The supernatant was discarded and the remaining QD pellet was further dissolved in neat DMF (fourth solvent) to prepare an ink that is ready for spin-coating or printing process.

Figure 5 shows the absorption spectrum of the obtained ink of Ag₂Te quantum dots. The resulting Ag₂Te quantum dots show first exciton peak at ~1350nm, and could be used to fabricate a light absorbing film. It also shows a distinct excitonic absorption peak, having a peak-valley ratio > 2.

As stated in a previous section, for some embodiments, the method of the second aspect of the present invention further comprises shelling the silver chalcogenide quantum dots with a shell made of a phosphine- and halide-free material.

Phosphines and halides are excluded from all the precursors used to grow that shell, leading to a final phosphine- and halide-free core-shell quantum dots structure.

One example is provided below for growing those shells, according to different embodiments:
Here, an example is given for growing ZnTe shell on Ag₂Te QDs. Other shells could follow a similar procedure. For growing ZnTe shell, Zn-OLAm mixture was first prepared with dissolving zinc acetate in oleylamine under pumping. Ag₂Te QDs in 1-Octadecene was then injected into the Zn-OLAm mixture under argon atmosphere and desired temperature. TeO₂-DDT, as tellurium precursor, was added dropwise using a syringe pump. After growing ZnTe shell, the QDs are purified with anti-solvents and redispersed into nonpolar solvents for further use.

A person skilled in the art could introduce changes and modifications in the embodiments described without departing from the scope of the invention as it is defined in the attached claims.

## Claims

1. A quantum dot population comprising silver chalcogenide quantum dots, **characterized in that** the silver chalcogenide quantum dots are phosphine- and halide-free.

2. The quantum dot population of claim 1, wherein the silver chalcogenide quantum dots are synthesized silver chalcogenide quantum dots.

3. The quantum dot population of any of the previous claims, wherein the silver chalcogenide quantum dots are passivated by amines and thiols.

4. The quantum dot population of any of the previous claims, wherein the silver chalcogenide quantum dots have distinct excitonic absorption peak, having a peak-valley ratio > 2, tuned from 1000nm to 2000nm.

5. The quantum dot population of claim 4, wherein the silver chalcogenide quantum dots have distinct excitonic absorption peak, having a peak-valley ratio > 2, tuned above 1300nm.

6. A method for obtaining the quantum dot population of any of the previous claims, **characterized in that** the method comprises obtaining the silver chalcogenide quantum dots without using phosphine or halide.

7. The method of claim 6, comprising:
- preparing silver precursor from amines and at least one silver compound;
- preparing chalcogenide precursor from chalcogen oxide and thiols; and
- synthesizing the silver chalcogenide quantum dots by injecting both the silver precursor and the chalcogenide precursor into a solution.

8. The method of claim 7, comprising providing said solution by loading pre-dried hydrocarbon solvents under inert atmosphere heating at a temperature between 20°C and the boiling point of said pre-dried hydrocarbon solvents.

9. The method of claim 7 or 8, further comprising adding extra metal precursor as post-synthesis treatment to stabilize the silver chalcogenide quantum dots in solvents without ripening.

10. The method of claim 6, comprising:
- preparing silver precursor from amines and at least one silver compound;
- preparing chalcogenide precursor from chalcogen oxide and thiols; and
- loading said silver and chalcogenide precursors in a hydrocarbon solvent followed by a heat-up process from room temperature to the boiling point of said hydrocarbon solvent.

11. The method of any of claims 7 to 10, wherein:
- said step of preparing silver precursor from said at least one silver compound comprises pre-drying amines under vacuum and dissolving said at least one silver compound in pre-dried amines with various concentrations at mild temperature, between 20°C and 100°C, in inert atmosphere; and/or
- said step of preparing chalcogenide precursor comprises mixing chalcogen oxide with thiols in inert atmosphere under mild temperature heating, between 50°C and 150°C, and continuous inert gas bubbling.

12. The method of any of claims 6 to 11, wherein said silver chalcogenide quantum dots are organic ligands capped silver chalcogenide quantum dots, and the method further comprises performing a ligand-exchange on surface of the silver chalcogenide quantum dots, for providing the same with ligands with a shorter chain than said organic ligands.

13. The method of any of claims 6 to 11, further comprising preparing an ink with the obtained silver chalcogenide quantum dots, by performing the following steps:
- preparing a silver chalcogenide quantum dot solution by dissolving organic ligands capped silver chalcogenide quantum dots into a first solvent;
- preparing a ligand solution by dissolving desired ligands into a second solvent, wherein said second solvent is not miscible with said first solvent, and wherein said desired ligands have a shorter chain than said organic ligands;
- doing phase transfer ligand exchange by mixing said silver chalcogenide quantum dot solution with said ligand solution, wherein two phases are obtained: a first phase containing said first solvent and exchanged organic ligands, and a second phase containing said second solvent with ligand-exchanged quantum dots;
- precipitating said ligand-exchanged quantum dots by adding a third solvent into the second phase; and
- and preparing quantum dot inks by dissolving said ligand-exchanged silver chalcogenide quantum dots into a fourth solvent.

14. An optoelectronic device, comprising the quantum dot population of any of claims 1 to 5.

15. The optoelectronic device of claim 14, wherein the optoelectronic device implements at least one of a photodetector device, a light emitting device and an image sensor.
